# EUROPEAN PATENT APPLICATION

(11) **EP 2 525 396 A2**
(43) Date of publication of application: **21.11.2012**
(21) Application number: 12001969.0
(22) Date of filing: 20.03.2012
(51) Int. Cl.: H01L 21/8234

(54) **Combined substrate high-k metal gate device and oxide-polysilicon gate device, and process of fabricating same**

(30) Priority: 20.05.2011 US 201161488301 P; 02.06.2011 US 201113152123
(71) Applicant: Broadcom Corporation, Irvine, CA 92617 (US)
(72) Inventor: Xiangdong, Chen, 92620 Irvine, CA (US); Wei, Xia, 92603 Irvine, CA (US)
(74) Representative: Jehle, Volker Armin

(57) **Abstract**

A semiconductor structure having combined substrate high-K metal gate device and an oxide-polysilicon gate device and a process of fabricating same are provided. The semiconductor structure enables mixed low power/low voltage and high power/high voltage applications to be supported on the same chip.

## Description

### Cross-Reference to Related Application(s)

The present application claims the benefit of U.S. Provisional Application No. 61/488,301, filed May 20, 2011, which is incorporated herein by reference in its entirety.

### Field of the Invention

This application relates generally to semiconductor devices and more particularly to a combined substrate high-K metal gate device and an oxide-polysilicon gate device and a process of fabricating same.

### Background

The semiconductor industry has experienced a rapid growth over the past few decades in the area of integrated circuits (ICs). Advancements in microelectronics have been the driving force behind the need for smaller and more complex ICs. The semiconductor industry has employed several strategies to meet the rapidly growing demands for decreasing the size of ICs. One approach is to reduce the thickness of the silicon oxide insulation on the gate of IC devices, such as transistors. This approach has been used for decades. However, the thickness of a silicon oxide insulator can only be reduced so much before current leakage becomes a concern.

In recent years, another approach has included the use of high K dielectrics and metal gates to form high-K metal gates. High K dielectrics are materials having a higher dielectric constant than silicon oxide. High K dielectrics can store more charge than silicon oxide, while using an equivalent thickness of insulation. As a result, increased reliability and lower leakage current can be achieved, particularly in ICs used for low power/low voltage applications. However, silicon oxide gates are still preferred when designs require the use of high power/ high voltage.

With the prevalence of low power/low voltage and high power/high voltage applications on the same chip, there is need for combined substrate high-K metal gate devices and oxide-polysilicon gate devices. In addition, there is a need that these combined substrate devices be fabricated in a single process.

### BRIEF SUMMARY OF THE INVENTION

According to an aspect, a semiconductor structure comprises:
a semiconductor substrate having a shallow trench isolation formation;
a first device having a high-K metal gate formed on the semiconductor substrate; and
a second device having an oxide-polysilicon gate formed on the semiconductor substrate;
wherein the first device and the second device are separated by the shallow trench isolation formation.

Advantageously, the high-K metal gate is formed using a high K dielectric and a metal.

Advantageously, the oxide-polysilicon gate includes a thick oxide layer, a polysilicon layer, and a silicide layer.

Advantageously, the high-K metal gate is fabricated using a replacement gate with dummy oxide and polysilicon layers.

Advantageously, the dummy oxide and polysilicon layers provide the thick oxide layer and the polysilicon layer of the oxide-polysilicon gate.

Advantageously, the semiconductor structure further comprises:
a first spacer, vertically attached to each sidewall of the high-K metal gate and a surface of the semiconductor substrate; and
a second spacer, vertically attached to each sidewall of the oxide-polysilicon gate and the surface of the semiconductor substrate.

Advantageously, the semiconductor structure further comprises:
a first source/drain region implanted within the semiconductor substrate on each side of the high-K metal gate, wherein the first source/drain region is laterally aligned with bases of the first spacer; and
a second source/drain region implanted within the semiconductor substrate on each side of the oxide-polysilicon gate, wherein the second source/drain region is laterally aligned with bases of the second spacer.

Advantageously, the semiconductor structure further comprises:
a silicide layer formed on the semiconductor substrate, the silicide layer serving as a contact for the first source/drain region and the second source/drain region.

Advantageously, the semiconductor structure further comprises:
a nitride layer deposited on the silicide layer, the nitride layer encases the oxide-polysilicon gate.

Advantageously, the nitride layer is planarized, by using a chemical mechanical polish, to expose a top surface of the oxide-polysilicon gate.

According to an aspect, a method comprises:
forming a shallow trench isolation (STI) formation between first and second device regions in a semiconductor substrate;
forming a dummy layer over a surface of the semiconductor substrate;
forming a first gate pattern over the first device region and a second gate pattern over the second device region using an etching process on the dummy layer, the first gate pattern providing a dummy gate and the second gate pattern providing an oxide-polysilicon gate;
removing the dummy gate from the surface of the semiconductor substrate forming an empty shell; and
forming a high-K metal gate within the empty shell using a high K dielectric and a metal.

Advantageously, forming the high-K metal gate comprises:
performing a high-K deposition on a bottom and side walls of the empty shell to form a thin layer of high-K dielectric along the bottom and side walls of the empty shell;
performing metal deposition to fill the remainder of the empty shell after the high-K deposition; and
performing a chemical mechanical polish to flatten a top surface of the metal.

Advantageously, the dummy layer includes a thick oxide layer, a polysilicon layer, and a nitride layer.

Advantageously, the oxide-polysilicon gate includes a thick oxide layer, a polysilicon layer, and a silicide layer.

Advantageously, the method further comprises:
forming a first spacer on the surface of the semiconductor substrate, vertically attached to each sidewall of the dummy gate; and
forming a second spacer on the surface of the semiconductor substrate, vertically attached to each sidewall of the oxide-polysilicon gate.

Advantageously, forming the first spacer and the second spacer includes applying an oxide deposition over the surface of the semiconductor substrate, and forming the oxide deposition into a spacer shape using an etching process.

Advantageously, the method further comprises:
implanting a first source/drain region and a second source/drain region within the semiconductor substrate, wherein the first source/drain region is aligned to the first spacer and the second source/drain region is aligned to the second spacer.

Advantageously, the method further comprises:
forming a silicide layer on the semiconductor substrate, the silicide layer serving as a contact for the first source/drain region and the second source/drain region.

Advantageously, the method further comprises:
forming a nitride layer over the silicide layer, the nitride layer encases the oxide-polysilicon gate.

Advantageously, the method further comprises:
planarizing the nitride layer to expose a top surface of the oxide-polysilicon gate.

According to an aspect, a method is provided of fabricating a first semiconductor device and a second semiconductor device on a single semiconductor substrate, the first semiconductor device having a thin gate oxide and the second semiconductor device having a thick gate oxide, the method comprising:
forming a first gate region for the first semiconductor device and a second gate region for the second semiconductor device, each of the first and second gate regions having a thick oxide layer and a polysilicon layer;
implanting the semiconductor substrate under the first gate region and the second gate region to form a source and drain for the first semiconductor device and a source and drain for the second semiconductor device;
forming a first set of spacers around the first gate region and the second set of spacers around the second gate region;
removing the thick oxide layer and the polysilicon layer in the first gate region, forming an empty shell in the first gate region surrounded the first set of spacers; and
forming a high-K metal gate within the empty shell of the first gate region using a high K dielectric and a metal;
wherein the high-K dielectric gate supports a gate for the first semiconductor device, and the thick oxide layer and polysilicon layer support a gate for the second semiconductor device.

Advantageously, the first semiconductor device is a low voltage low power device, and the second semiconductor device is a high voltage high power device relative to the first semiconductor device.

Advantageously, the step of forming a high-K metal gate includes:
forming a high-K dielectric layer within the empty shell of the first gate region; and
forming a metal layer over the high-K dielectric layer to fill the empty shell and form the high-K metal gate.

Advantageously, forming a first gate region for the first semiconductor device and a second gate region for the second semiconductor device includes the steps of:
forming the thick oxide layer over the semiconductor substrate;
forming the polysilicon layer over the thick oxide layer; and
removing portions of the thick oxide layer and the polysilicon layer to define the first gate region and the second gate region.

Advantageously, the method further comprises the step of forming a silicide layer over the polysilicon layer in the second gate region prior to the removing step.

### Brief Description of the Drawings/Figures

The accompanying drawings, which are incorporated herein and form a part of the specification, illustrate the present invention and, together with the description, further serve to explain the principles of the invention and to enable a person skilled in the pertinent art to make and use the invention.

FIG. 1 illustrates a cross-sectional view of a semiconductor structure according to an embodiment of the present invention.

FIGs. 2a-2j illustrate a process of fabricating a semiconductor structure according to an embodiment of the present invention.

FIG. 3 illustrates a process flow chart of a method of fabricating a semiconductor structure according to an embodiment of the present invention.

The present invention will be described with reference to the accompanying drawings. The drawing in which an element first appears is typically indicated by the leftmost digit(s) in the corresponding reference number.

### Detailed Description of Embodiments

The need for both low-power/low-voltage devices and high-power/ high-voltage devices creates special challenges in the fabrication of high-K metal devices. Standard high-K metal gate processes normally fabricate two high K devices side-by-side. The high-K metal gate fabrication process includes the formation of two dummy polysilicon gates (dummy gates) on a substrate. These dummy gates are sacrificial structures that are replaced by high K metal gates. Under the typical process, the sacrificial structures are wasted and add no value to the fabrication process beyond the comment above. A second step, that is similar to the process described above, is then required to form a conventional oxide gate that is compatible with the high K metal gates. The second step of adding a conventional oxide gate adds complexity and increases costs associated with fabricating high K metal gates.

### 1. Combined Substrate High-K metal Gate Device and Oxide-Polysilicon Gate Device

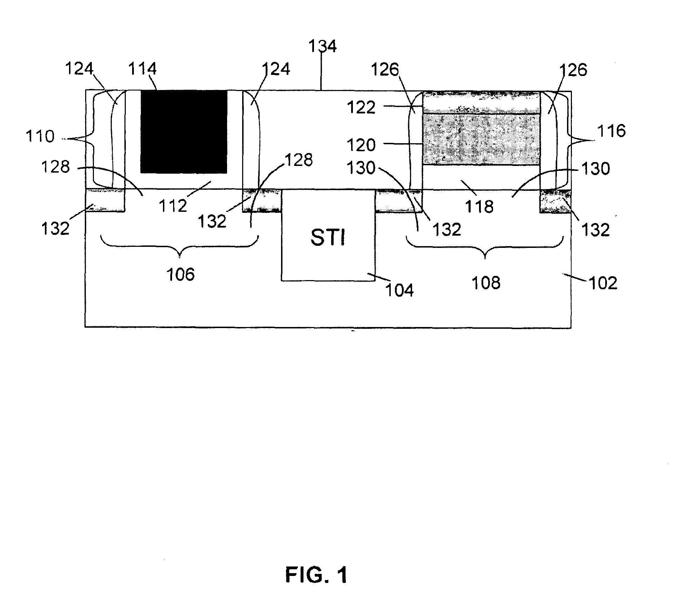

FIG. 1 illustrates a cross-sectional view of a semiconductor structure 100, according to an embodiment of the present invention. Structure 100 includes a semiconductor substrate 102 having a top surface and a bottom surface, a shallow trench isolation (STI) formation 104, a high K metal gate 110, an oxide-polysilicon gate 116, a first spacer 124, a second spacer 126, a first source/drain region 128, a second source/drain region 130, a silicide layer 132, and a nitride layer 134. Semiconductor substrate 102 may be made of Silicon or of any other semiconductor material. Semiconductor substrate 102 can also include compound semiconductors such as silicon carbide, gallium arsenide, indium arsenide, or indium phosphide. Semiconductor substrate 102 (referred to hereafter as substrate) can also include a variety of doping configurations related to design requirements, such as, p-type substrate or n-type substrate.

STI formation 104 is formed within substrate 102. STI formation 104 may include silicon oxide, silicon nitride, silicon oxynitride, a low K dielectric, or other suitable materials. STI formation 104 may be used to delineate a first device region 106 and a second device region 108. For example, first device region 106 can include a region for a positive metal oxide semiconductor (PMOS) device and second device region 108 can include a region for a negative metal oxide semiconductor (NMOS) device, or vice-a-versa. High-K metal gate 110 and oxide-polysilicon gate 116 can be either a PMOS device or an NMOS device.

High-K metal gate 110 may be formed in first device region 106 on the surface of substrate 102. High-K metal gate 110 includes a high K dielectric 112 and a metal 114. High-K dielectric 112 has a relative dielectric constant of 19-20, and can have a thickness that ranges from 8-15A, for example. High K dielectric 112 may be hafnium dioxide, hafnium silicate, zirconium dioxide, titanium dioxide, aluminum oxide, tantalum pentoxide, or other suitable high K dielectric. The type of metal 114 used may depend on whether high-K metal gate 110 is designed to be an NMOS device or a PMOS device. High K dielectric 112 is formed on the surface of substrate 102 and is used to insulate metal 114.

Oxide-polysilicon gate 116 is formed adjacent to high-K metal gate 110 on the surface of substrate 102. Gate 116 may be located in second device region 108. Gate 116 includes a thick oxide layer 118, a polysilicon layer 120, and a silicide layer 122. The oxide layer 118 has a relative dielectric constant of approximately 3.9, although others can be used. The thickness of oxide layer 118 can vary depending on the desired performance of the gate 116, and can be approximately 25-75A. Therefore, thick oxide layer 118 is thicker than that of high-K oxide layer 112 in device 106, as illustrated in FIG.1. Silicide layer 122 may be used as a contact for gate 116.

First spacer 124 and the second spacer 126 are formed on the surface of substrate 102, vertically attached, respectively, to both sidewalls of high K metal device gate 110 and oxide-polysilicon gate 116, as shown in FIG. 1. For example, first spacer 124 and second spacer 126 can be used to protect first device region 106 and second device region 108 during the fabrication of gate devices. First spacer 124 and second spacer 126 can be formed of silicon dioxide, silicon nitride, silicon oxynitride, silicon carbide, titanium nitride, various low-k dielectrics and any other suitable material or combinations. Bases of first spacer 124 and second spacer 126 can also be used as boundaries for first source/drain region 128 and second source/drain region 130, where the bases are the bottom surfaces and in contact with silicide layer 132.

First source/drain region 128 and second source/drain region 130 can be aligned using the base of the first spacer 124 and the base of the second spacer 126. Implanting p-type or n-type dopants within substrate 102 can form first source/drain region 128 and the second source/drain region 130. For example, first source/drain region 128 and second source/drain region 130 can be built by doping substrate 102 with impurities such as arsenic, phosphorus, or boron. Doping with boron adds positive charges making a p-type region, while doping with arsenic or phosphorus adds electrons making an n-type region. Alternatively, other impurities can also be used to achieve the preferred n-type or p-type configurations.

Silicide layer 132 is placed over first source/drain region 128 and second source/drain region 130 that are implanted within substrate 102. By way of example, silicide layer 132 can be used as a contact for first source/drain region 128 and second source/drain region 130. The silicide layer 132 can be nickel silicide, sodium silicide, magnesium silicide, platinum silicide, palladium silicide, and titanium silicide or other compatible combination.

Nitride layer 134 is deposited over silicide layer 132 that is formed over the surface of substrate 102. Nitride layer 134 can be further deposited over high-K metal gate 110 and gate 116. For example, nitride layer 134 can be used to provide insulation to high-K metal gate 110 and gate 116. Nitride layer 134 can be planarized using chemical mechanical polish (CMP) to expose the top surfaces of high-K metal gate 110 and gate 116. The CMP can also be used to flatten the top surface of the nitride layer.

The advantage of semiconductor structure 100 is that the high-K metal gate device 106 is fabricated on the same silicon IC as the oxide-polysilicon gate device 108, without an additional processing run. The high-K metal gate device 106 provides a low power, low voltage device, whereas the oxide-polysilicon gate device 108 provides a higher voltage breakdown and higher power device that is useful for input/output functionality. The high-K metal gate device 106 has a thinner oxide layer 112 compared to the thick oxide layer 118, which enables lower gate turn-on voltages, and therefore lower power compared to the thick oxide-polysilicon gate device 108. By having both devices 106 and 108 adjacent to one another on the same silicon, the semiconductor structure 100 can service both the low voltage domain and the high voltage domain in the same integrated circuit.

### 2. Method of fabrication

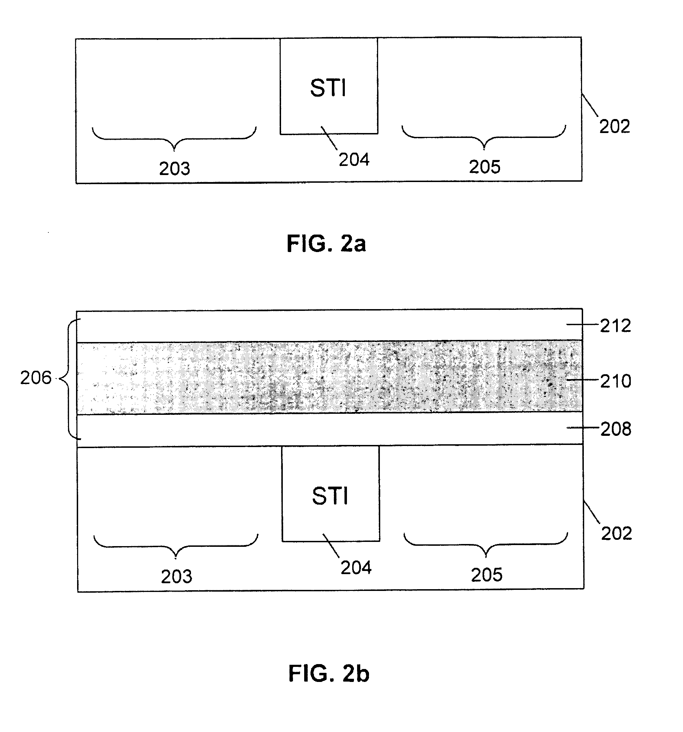

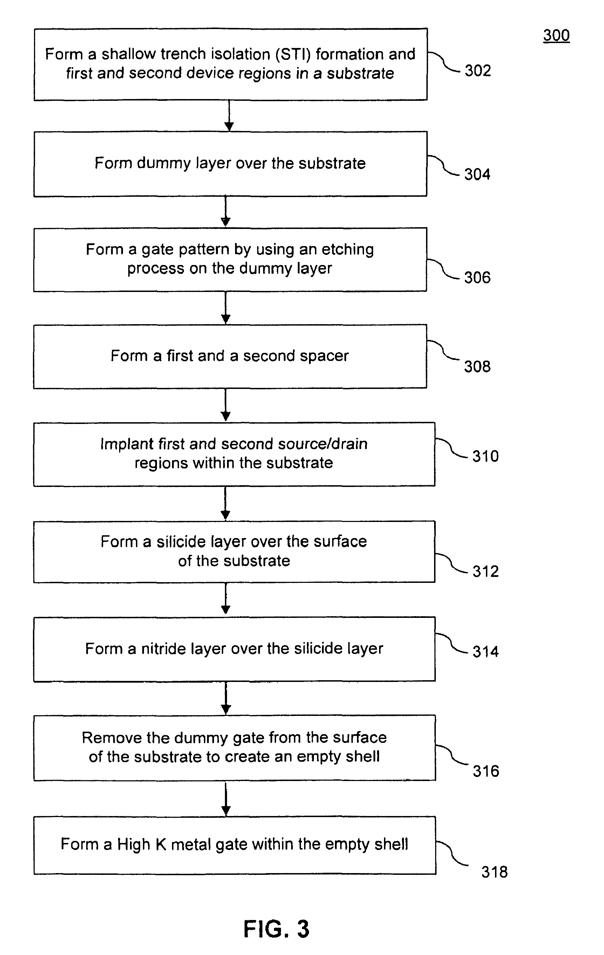

FIGs. 2a - 2j illustrate a process of fabricating a semiconductor structure (e.g., semiconductor structure 100) according to an embodiment of the present invention. The process shown in FIGs. 2a-2j corresponds to process 300 illustrated in FIG. 3, which is described below. As would be understood by a person of skill in the art, process 300 may not occur in the order shown, or require all of the steps shown.

Process 300 begins at step 302, which includes forming a shallow trench isolation (STI) region and first and second device regions in a substrate. Step 302 is illustrated in FIG. 2a, which shows a substrate 202 having a STI formation 204 and first and second device regions 203 and 205, which can correspond to device regions 106 and 108, respectively. Substrate 202 may be made of Silicon or of any other semiconductor material. Substrate 202 can also include compound semiconductors such as, silicon carbide, gallium arsenide, indium arsenide, or indium phosphide. Substrate 202 can include a variety of doping configurations related to design requirements such as, p-type substrate or n-type substrate.

STI formation 204 can be formed using an etching process to form a trench. For example, one of the following etching processes can be used such as dry etching, wet etching photochemical etching or plasma etching. Once the trench is formed, a deposition process can be used to fill the trench with an insulator. For example, STI formation 204 can be filled with silicon oxide, silicon nitride, silicon oxynitride, or a low K dielectric. The surface of STI formation 204 can be smoothed and flattened with a CMP. As shown in FIG. 2a, STI formation 204 can be used to define first device region 203 and second device region 205 of substrate 202. Further doping to form wells in first and second device regions 203 and 204 may also be performed in step 302.

Process 300 then continues at step 304, illustrated in FIG. 2b, which includes forming a dummy layer 206 over substrate 202. Dummy layer 206 may include a thick oxide layer 208, a polysilicon layer 210 and a nitride layer 212. Dummy layer 206 can be formed using one of a variety of deposition processes such as, atomic layer deposition, chemical vapor deposition, physical vapor deposition, plasma enhanced atomic layer deposition, molecular beam epitaxy, ion beam assisted deposition, or other suitable deposition processes.

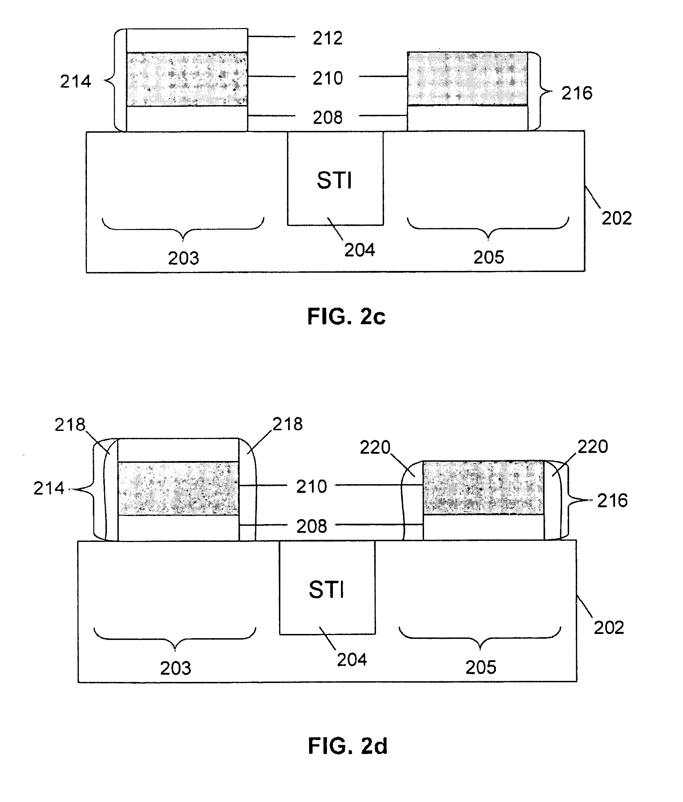

Process 300 then proceeds to step 306, illustrated in FIG. 2c, which includes forming a gate pattern on dummy layer 206. In an embodiment, gate patterning is done using an etching process, such as, dry etching, wet etching, or plasma etching. Furthermore, a masking process can also be used to form gate patterns. As shown in FIG. 2c, step 306 forms a dummy gate 214 in first device region 203 and an oxide-polysilicon gate 216 in second device region 205.

Dummy gate 214 retains the composition of dummy layer 206. By way of example, dummy gate 214 may include a thick oxide layer 208, a polysilicon layer 210, and a nitride layer 212. Gate 216 can have a different composition than dummy layer 206. For example, gate 216 may include a thick oxide layer 208 and a polysilicon layer 210. Gate 216 does not include nitride layer 212 after the etching process is completed. During processing, the nitride layer is first added across the entire structure 100, and them nitride layer 212 is selectively etched away from the gate 216 and therefore exposes its polysilicon layer 210 as shown. However, the nitride layer 212 remains for the dummy gate 214. Alternatively, the removal of the nitride layer of the gate 216 may occur during another step in the fabrication process.

Process 300 then continues at step 308, illustrated in FIG. 2d, which includes forming a first spacer 218 and a second spacer 220 on the substrate. In an embodiment, as shown in FIG. 2d, first spacer 218 is vertically attached to both sidewalls of dummy gate 214, and second spacer 220 is vertically attached to both sidewalls of gate 216. By way of example, first spacer 218 and second spacer 220 can be formed of silicon dioxide, silicon nitride, silicon oxynitride, silicon carbide, titanium nitride, various low K dielectrics and any combination thereof. First spacer 218 and second spacer 220 can be formed by using one of the deposition processes mentioned above and by applying an anisotropic etching technique to shape the desired spacer characteristics.

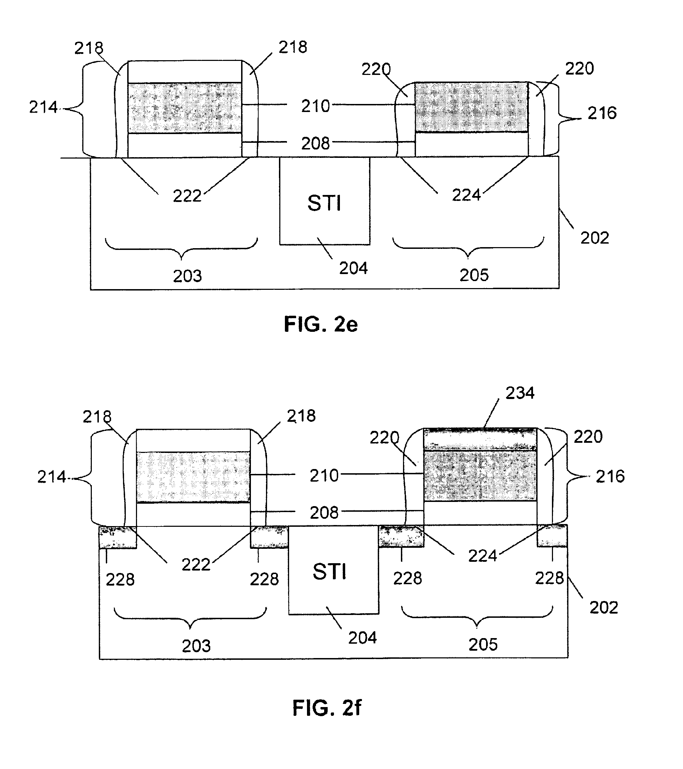

Process 300 then proceeds to step 310, illustrated in FIG. 2e, which includes implanting first and second source/drain regions 222 and 224 within the substrate. In an embodiment, first source/drain region 222 and second source/drain region 224 can use the base of first spacer 218 and second spacer 220 to define an area of substrate 202 in which dopants can be implanted. By way of example, first source/drain region 222 can be laterally implanted within substrate 202 beside each sidewall of dummy gate 214, and second source/drain region 224 can be laterally implanted within substrate 202 beside each sidewall of gate 216, or vice versa. In an embodiment, first source/drain region 222 and second source/drain region 224 are constructed by doping substrate 202 with impurities, such as, arsenic, phosphorus, or boron. Doping with boron adds positive charges making an p-type region, while doping with arsenic or phosphorus adds electrons making an n-type region. Other impurities can also be used to achieve the preferred configurations. First source/drain region 222 and second source/drain region 224 can be formed by using processes such as, ion implantation, diffusion, and photolithography.

Process 300 then proceeds to step 312, illustrated in FIG. 2f, which includes forming a silicide layer 228 over the surface of substrate 202 and another silicide layer 234 over gate 216. In particular, silicide layer 228 is formed over first source/drain region 222 and second source/drain region 224 that are implanted within substrate 202. Silicide layer 234 is formed over polysilicon layer 210 of gate 216. By way of example, silicide layer 228 can be used as a contact for first source/drain 222 and second source/drain 224, and silicide layer 234 can be used as a contact for gate 216.

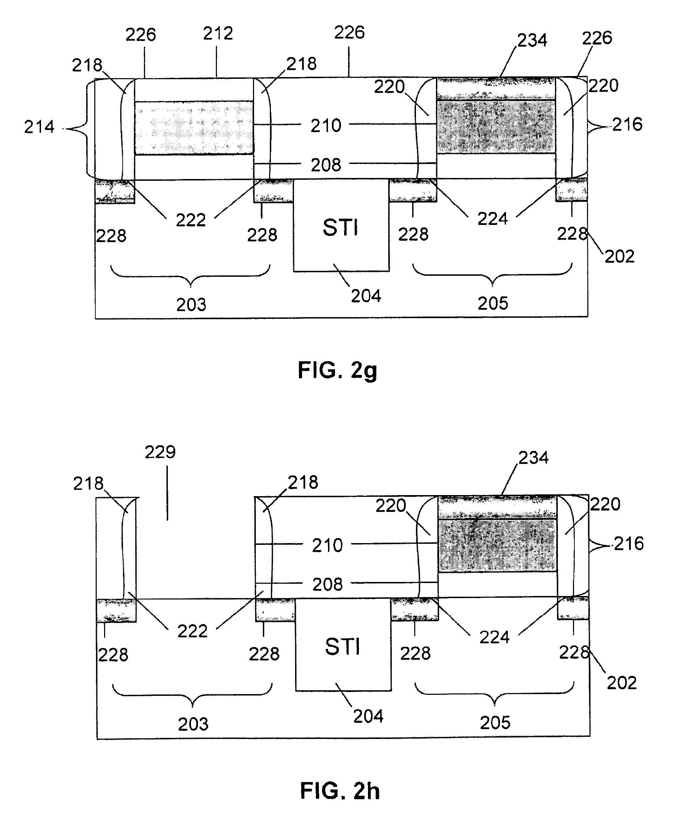

Process 300 then proceeds to step 314, illustrated in FIG. 2g, which includes forming a nitride layer 226 over silicide layer 228. Nitride layer 226 can be formed by using a variety of deposition techniques mentioned above. Nitride layer 226 insulates first device region 203 and second device region 205. For example, nitride layer 226 is deposited over silicide layer 228 so as to encase dummy gate 214 and gate 216. The top surface of nitride layer 226 can be polished back, using a CMP, to expose a top surface of dummy gate 214 and a top surface of gate 216. The dummy gate 214 that is formed at this point is only temporary, (hence the name dummy), and only provides a placeholder for the deposition of the high-K metal gate 110 to follow.

Process 300 continues at step 316, illustrated in FIG. 2h, which includes removing dummy gate 214 from the surface of substrate 202 leaving an empty shell 229. Dummy gate 214 can be removed using etching processes, such as, wet etching, photochemical etching, dry etching, plasma etching, or other known etching processes.

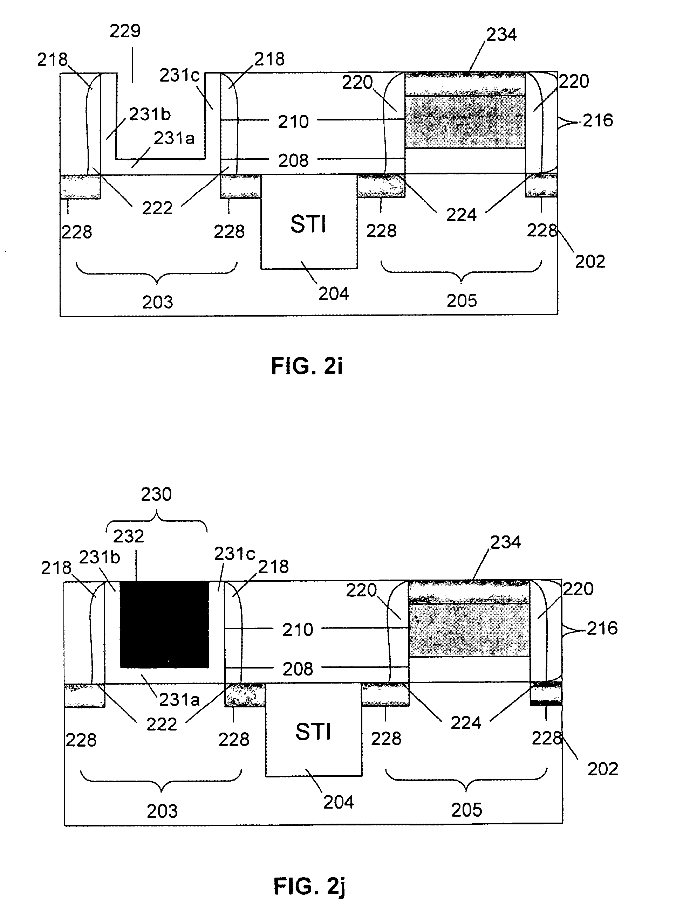

Process 300 terminates at step 318, as illustrated in FIGs. 2i-2j, which includes forming a high-K metal gate 230 within the empty shell 229. High-K metal gate 230 is formed by using a high K dielectric 231 and a metal 232. First, high K dielectric 231 is deposited as a thin layer 231a-c along the bottom and sidewalls of empty shell 229, as shown in FIG. 2i. As indicated above, the thickness of thin layers 231a-c can be approximately 8-15A, as compared with 25-75A for the thick oxide 208. For example, high K dielectric 231 can be hafnium dioxide, zirconium dioxide, titanium dioxide or other suitable materials. Furthermore, high K dielectric 231 can be deposited using one of the various deposition processes such as, atomic layer deposition, chemical vapor deposition, physical vapor deposition, plasma enhanced atomic layer deposition, molecular beam epitaxy, ion beam assisted deposition, or other suitable deposition processes.

Subsequently, after the high K dielectric layer 231 is deposited, then the shell is further filled with metal 232 to completely fill the inner portion of the shell 239 as shown in FIG. 2j, resulting in dielectric layers 231a-c at least partially encasing the metal 232 to form the high-k metal gate 230. The type of metal 232 can include TiN and TaN.

According to embodiments, process 300 may be used during fabrication of an integrated circuit that can comprise static random device access memory (SRAM) and/or other logic circuits, passive components such as resistor, capacitors, and inductors, and active components such as P-channel field effect transistors (PFET), N-channel field effect transistors (NFET), metal oxide semiconductor field effect transistor (MOSFET), complementary metal oxide semiconductor field effect transistor (CMOS), bipolar transistor, high voltage transistor, and other similar devices.

### 3. Conclusion

It is to be appreciated that the Detailed Description section, and not the Abstract section, is intended to be used to interpret the claims. The Abstract section is intended to be used to interpret the claims. The Abstract section may set forth one or more but not all exemplary embodiment of the present invention as contemplated by the inventor(s), and thus, is not intended to limit the present invention and the appended claims in any way.

The present invention has been described above with the aid of functional building blocks illustrating the implementation of specified functions and relationships thereof. The boundaries of these functional building blocks have been arbitrarily defined herein for the convenience of the description. Alternate boundaries can be defined so long as the specified functions and relationships thereof are appropriately performed.

The foregoing description of the specific embodiments will so fully reveal the general nature of the invention that others can, by applying knowledge within the skill of the art, readily modify and /or adapt for various applications such specific embodiments, without undue experimentation, without departing form the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

## Claims

1. A semiconductor structure, comprising:
a semiconductor substrate having a shallow trench isolation formation;
a first device having a high-K metal gate formed on the semiconductor substrate; and
a second device having an oxide-polysilicon gate formed on the semiconductor substrate;
wherein the first device and the second device are separated by the shallow trench isolation formation.

2. The semiconductor structure of claim 1, wherein the high-K metal gate is formed using a high K dielectric and a metal.

3. The semiconductor structure of claim 1, wherein the oxide-polysilicon gate includes a thick oxide layer, a polysilicon layer, and a silicide layer.

4. The semiconductor structure of claim 3, wherein the high-K metal gate is fabricated using a replacement gate with dummy oxide and polysilicon layers.

5. The semiconductor structure of claim 4, wherein the dummy oxide and polysilicon layers provide the thick oxide layer and the polysilicon layer of the oxide-polysilicon gate.

6. The semiconductor structure of claim 1, further comprising:
a first spacer, vertically attached to each sidewall of the high-K metal gate and a surface of the semiconductor substrate; and
a second spacer, vertically attached to each sidewall of the oxide-polysilicon gate and the surface of the semiconductor substrate.

7. The semiconductor structure of claim 6, further comprising:
a first source/drain region implanted within the semiconductor substrate on each side of the high-K metal gate, wherein the first source/drain region is laterally aligned with bases of the first spacer; and
a second source/drain region implanted within the semiconductor substrate on each side of the oxide-polysilicon gate, wherein the second source/drain region is laterally aligned with bases of the second spacer.

8. The semiconductor structure of claim 7, further comprising:
a silicide layer formed on the semiconductor substrate, the silicide layer serving as a contact for the first source/drain region and the second source/drain region.

9. The semiconductor structure of claim 8, further comprising:
a nitride layer deposited on the silicide layer, the nitride layer encases the oxide-polysilicon gate.

10. The semiconductor structure of claim 9, wherein the nitride layer is planarized, by using a chemical mechanical polish, to expose a top surface of the oxide-polysilicon gate.

11. A method, comprising:
forming a shallow trench isolation (STI) formation between first and second device regions in a semiconductor substrate;
forming a dummy layer over a surface of the semiconductor substrate;
forming a first gate pattern over the first device region and a second gate pattern over the second device region using an etching process on the dummy layer, the first gate pattern providing a dummy gate and the second gate pattern providing an oxide-polysilicon gate;
removing the dummy gate from the surface of the semiconductor substrate forming an empty shell; and
forming a high-K metal gate within the empty shell using a high K dielectric and a metal.

12. The method of claim 11, wherein forming the high-K metal gate comprises:
performing a high-K deposition on a bottom and side walls of the empty shell to form a thin layer of high-K dielectric along the bottom and side walls of the empty shell;
performing metal deposition to fill the remainder of the empty shell after the high-K deposition; and
performing a chemical mechanical polish to flatten a top surface of the metal.

13. The method of claim 11, wherein the dummy layer includes a thick oxide layer, a polysilicon layer, and a nitride layer.

14. The method of claim 11, wherein the oxide-polysilicon gate includes a thick oxide layer, a polysilicon layer, and a silicide layer.

15. A method of fabricating a first semiconductor device and a second semiconductor device on a single semiconductor substrate, the first semiconductor device having a thin gate oxide and the second semiconductor device having a thick gate oxide, the method comprising:
forming a first gate region for the first semiconductor device and a second gate region for the second semiconductor device, each of the first and second gate regions having a thick oxide layer and a polysilicon layer;
implanting the semiconductor substrate under the first gate region and the second gate region to form a source and drain for the first semiconductor device and a source and drain for the second semiconductor device;
forming a first set of spacers around the first gate region and the second set of spacers around the second gate region;
removing the thick oxide layer and the polysilicon layer in the first gate region, forming an empty shell in the first gate region surrounded the first set of spacers; and
forming a high-K metal gate within the empty shell of the first gate region using a high K dielectric and a metal;
wherein the high-K dielectric gate supports a gate for the first semiconductor device, and the thick oxide layer and polysilicon layer support a gate for the second semiconductor device.
